# EUROPEAN PATENT SPECIFICATION

(11) **EP 2 733 590 B1**
(45) Date of publication and mention of the grant of the patent: **26.07.2017**
(21) Application number: 13250108.1
(22) Date of filing: 31.10.2013
(51) Int. Cl.: G06F 3/044, H03K 17/96

(54) **Touch sensor and method of manufacturing the same**
Berührungssensor und Verfahren zur Herstellung davon
Capteur tactile et son procédé de fabrication

(30) Priority: 14.11.2012 JP 2012249827
(43) Date of publication of application: 21.05.2014
(73) Proprietor: Hosiden Corporation, Yao-shi, Osaka 581-0071 (JP)
(72) Inventor: Isoda, Takeshi, Yao-shi, Osaka, 581-0071 (JP); Ao, Hitoshi, Yao-shi, Osaka, 581-0071 (JP)
(74) Representative: Beresford, Keith Denis Lewis

(56) References cited:
- JP-A- 2010 094 883
- KR-A- 20120 018 059
- US-A1- 2004 265 602
- US-A1- 2009 107 736
- US-A1- 2010 134 429
- US-A1- 2011 109 583

## Description

The invention relates to capacitive touch sensors and methods of manufacturing the touch sensors.

A conventional touch sensor of this kind is disclosed in WO2010/095797. This touch sensor includes a plurality of layers and an optically clear adhesive for bonding the layers.

In recent years, touch sensors have been used for an increasing range of uses, and there have been demands for use under harsh environments, such as under high-temperature environments (e.g. in a car having an internal temperature of 50 degrees or higher) and under a condition that the touch sensor is bent in a curved shape. Touch sensors used under such harsh environments are subject to increased stress factors, such as differences in shrinkage ratio between layered members, differences in residual stress between the layers, and outgassing from the layers.

In the above conventional touch sensor, the layers are bonded together only with an optically clear adhesive. The above stress factors exerted on the layers over time may cause delamination because the optically clear adhesive may not be able to provide the layers with a sufficient level of bonding strength therebetween.

In view of the above circumstances, the invention provides a touch sensor having layers with improved bonding strength therebetween. The invention also provides a method of manufacturing the touch sensor.

A touch sensor according to the invention includes first and second layers and a first welding layer. The first and second layers are laminated together. The first welding layer is provided between the first and second layers for welding the first and second layers together at least partially.

In the touch sensor of this aspect of the invention, the first welding layer welds the first and second layers together at least partially, increasing the bonding strength between the first and second layers. Therefore, the invention can reduce the possibility of delamination of the first and second layers even if used under a harsh environment.

At least one layer of the first and second layers may be a plastic layer. The first welding layer may be made from a portion of the one layer that has melted and then solidified to weld the one layer at least partially to the other layer of the first and second layers.

In the touch sensor of this aspect, one and the other layers are welded together utilizing a portion of the one layer, leading to a reduced number of components and welding steps.

The touch sensor may further include an electrode layer provided between the first and second layers.

The electrode layer may include a meshed or fibrous electrode including interstices, i.e., the electrode layer may comprise a mesh or may comprise woven or unwoven fibres, any of which may include interstices. The first welding layer may weld to the other layer through the interstices of the electrode.

In the touch sensor of this aspect, the first welding layer welds to the other layer through the interstices of the electrode. Therefore, the bonding strength between the first and second layers will not be adversely affected by providing the electrode layer between the first and second layer.

The touch sensor may further include a third layer and a second welding layer. The third layer may be laminated to the second layer. The second welding layer may be provided between the second and third layers and welding the second and third layers together at least partially.

In the touch sensor of this aspect, the second and third layers are welded together at least partially by the second welding layer, leading to an improved bonding strength between the second and third layers. Therefore, this aspect of the invention can reduce the possibility of delamination of the second and third layers even if used under a harsh environment.

At least one layer of the second and third layers may be a plastic layer. The second welding layer may be made from a portion of the one layer of the second and third layers that has melted and then solidified to weld the one layer at least partially to the other layer of the second and third layers.

In the touch sensor of this aspect, one and the other layers are welded together utilizing a portion of the one layer, leading to a reduced number of components and welding steps.

The second layer may be a buffer layer made of a plastic material more suitable to be welded to the first and third layers, rather than welding the first and third layers to each other directly. The first welding layer may be made from a portion of the buffer layer that has melted and then solidified to weld the buffer layer to the first layer. The second welding layer may be made from another portion of the buffer layer melted and then solidified to weld the buffer layer to the third layer.

In the touch sensor of this aspect, the first layer and the third layer, if having poor welding compatibility with each other, can bond to each other through the second layer.

The buffer layer may be made of a thermoplastic plastic material having a melting point lower than those of the first and third layers.

In the touch sensor of this aspect, a portion of the buffer layer melts before the first layer and the third layer do. This configuration can reduce thermal damage to the first and third layers during the welding process.

The third layer may be a cover panel layer or a reinforcing layer.

The second layer may be a protective layer to protect the electrode layer.

In the touch sensor of this aspect, the protective layer covering the electrode layer can prevent the electrode layer from directly contacting a welding machine during the welding process. Therefore, the electrode layer is less likely to be physically damaged during the welding process.

The first layer may be a cover panel layer.

At least one of the first, second, and third layers may be in film shape, i.e. may be in the form of a film.

The first and second layers may have translucency. The first, second, and third layers may have translucency.

A method of manufacturing a touch sensor according to the invention includes laminating a first and a second layer together, at least one layer of the first and second layers being a plastic layer, and welding the one layer at least partially to the other layer of the first and second layers by melting and then solidifying a portion of the one layer.

In the manufacturing method of this aspect, a portion of the one layer of the first and second layers melts and then solidifies to weld the one layer to the other layer at least partially, so that the bonding strength between the first and second layers is improved. Therefore, the method of this aspect can reduce the possibility of delamination of first and second layers even if used under a harsh environment. Further advantageously, one and the other layers are welded together utilizing a portion of the one layer, leading to a reduced number of components and welding steps.

The method may further include placing the laminated first and second layers in a die, and injection-molding a plastic material on the second layer in the die to laminate a third layer on the second layer. The welding of the one layer at least partially to the other layer may include melting the portion of the one layer of the first and second layers by use of heat and pressure during the injection molding process and solidifying the melted portion of the one layer.

In the manufacturing method of this aspect, while the third layer is molded on the second layer, the first and second layers can be welded. Thus, the number of the welding steps of the touch sensor can be reduced.

The method may further include forming an electrode layer on one of the first and second layers prior to the laminating of the first and second layers together.

The electrode layer may include a meshed or fibrous electrode including interstices. The welding of the one layer at least partially to the other layer may include bonding the melted portion of the one layer to the other layer through the interstices of the electrode and then solidifying the melted portion of the one layer.

In the manufacturing method of this aspect, the bonding strength between the first and second layers will not be adversely affected by providing the electrode layer between the first and second layers.

One layer of the second layer and a third layer may be made of a plastic material. The method may further include laminating the third layer on the second layer and welding the one layer at least partially to the other layer of the second and third layers by melting and then solidifying a portion of the one layer.

In the manufacturing method of this aspect, the second and third layers are welded together utilizing a portion of one of these layers, leading to a reduced number of components and welding steps.

The second layer may be a buffer layer made of a plastic material more suitable to be welded to the first and third layers rather than welding the first and third layers to each other directly.

The manufacturing method of this aspect can weld the first and third layers together if they have poor welding compatibility with each other.

The buffer layer may be made of a thermoplastic plastic material having a melting point lower than those of the first and third layers.

In the manufacturing method of this aspect, a portion of the buffer layer melts before the first and third layers do. The method can therefore reduce thermal damage to the first and third layers during the welding process.

The second layer may be a protective layer to protect the electrode layer. In the manufacturing method of this aspect, the protective layer covering the electrode layer can prevent the electrode layer from directly contacting a welding machine during the welding process. Therefore, the electrode layer is less likely to be physically damaged during the welding process.

The first layer may be a cover panel layer. The third layer may be a cover panel layer or a reinforcing layer.

The invention will now be described by way of example only and without limitation by reference to the drawings, in which:
Fig. 1 is a schematic cross-sectional view of a touch sensor according to a first embodiment of the invention.
Fig. 2 illustrates the positional relationship of first and second electrode layers of the touch sensor of the first embodiment.
Fig. 3A is an enlarged view of an area α in Fig. 2, in a case where the electrode layer of the touch sensor includes meshed electrodes.
Fig. 3B is an enlarged view of an area α in Fig. 2, in a case where the electrode layer of the touch sensor includes fibrous electrodes.
Fig. 4 illustrates steps of manufacturing the touch sensor of the first embodiment.
Fig. 5 is a schematic cross-sectional view of a touch sensor according to a second embodiment of the invention.
Fig. 6 illustrates steps of manufacturing the touch sensor of the second embodiment.
Fig. 7 is a schematic cross-sectional view showing a variant of the touch sensor of the first embodiment.

The following discusses first and second embodiments of the invention.

### First embodiment

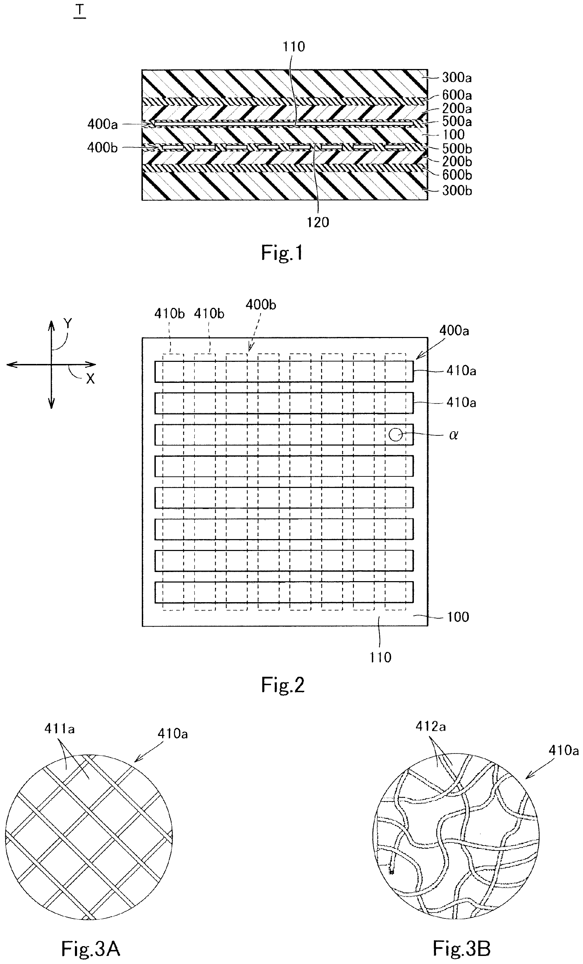

First, a touch sensor T according to the first embodiment of the invention will be described with reference to Figs. 1 to 4. The touch sensor T is a capacitive touch panel as shown in Fig. 1. The touch sensor T includes a base layer 100 (first layer), a buffer layer 200a (second layer), a protective layer 200b (second layer), a cover panel layer 300a (third layer), a reinforcing layer 300b (third layer), electrode layers 400a and 400b, first welding layers 500a and 500b, and second welding layers 600a and 600b. Hereinafter, each of these elements of the touch sensor T will be described in detail.

The base layer 100 as shown in Fig. 1 is a flexible transparent plastic film, for example made of PET (polyethylene terephthalate), polycarbonate, PMMA (polymethyl methacrylate) or the like. The base layer 100 has a first face 110 and a second face 120 in a thickness direction of the base layer 100.

As shown in Fig. 1, the buffer layer 200a is laminated to the first face 110 of the base layer 100 and welded to the base layer 100 by the first welding layer 500a. The buffer layer 200a is made of a plastic material that is more suitable to be welded to the base layer 100 and the cover panel layer 300a, rather than welding the base layer 100 and the cover panel layer 300a to each other directly. More specifically, the buffer layer 200a is a flexible transparent film of thermoplastic plastic material (e.g. acrylic resin or polyurethane) having a melting point lower than those of the base layer 100 and the cover panel layer 300a.

The first welding layer 500a is made from a portion of the base layer 100 and a portion of the buffer layer 200a (i.e. respective portions of these layers contacting each other) that melt, get into interstices 411 a or 412a of electrodes 410a of the electrode layer 400a (to be described), bond to the base layer 100 and the buffer layer 200a, and then solidify. The first welding layer 500a welds the entire surface areas of the base layer 100 and the buffer layer 200a.

As shown in Fig. 1, the electrode layer 400a is provided between the base layer 100 and the buffer layer 200a and embedded in the first welding layer 500a. As shown in Fig. 2, the electrode layer 400a includes a plurality of strip-shaped electrodes 410a. The electrodes 410a are electrically conductive flexible films. The electrodes 410a are in mesh form as shown in Fig. 3A or fibrous form as shown in Fig. 3B. The meshed electrodes 410a are made of wires of metal, such as silver and copper, formed in lattice shape including interstices 411 a. The fibrous electrodes 410a are made of electrically conductive fibers, such as electrically conductive nanowires (e.g. silver nanowires) and carbon nanotubes (CNTs), put together to include interstices 412a. The electrodes 410a of the electrode layer 400a are arrayed in spaced relation to each other along a first direction Y. The electrode layer 400a is connectable to a connecting means (not shown) such as a sheet-form connecting element or a flexible circuit board.

As shown in Fig. 1, the cover panel layer 300a is laminated to the buffer layer 200a and welded to the buffer layer 200a by the second welding layer 600a. The cover panel layer 300a is a flexible transparent plastic film, for example made of PET (polyethylene terephthalate), polycarbonate, PMMA (polymethyl methacrylate), or the like.

The second welding layer 600a is made from a portion of the buffer layer 200a and a portion of the cover panel layer 300a (i.e. respective portions of these layers contacting each other) that melt, bond to the buffer layer 200a and the cover panel layer 300a, and then solidify. The second welding layer 600a welds the entire surface areas of the buffer layer 200a and the cover panel layer 300a.

The protective layer 200b is laminated to the second face 120 of the base layer 100 and welded to the base layer 100 by the first welding layer 500b. The protective layer 200b is a flexible transparent film of a plastic material such as polymer. The protective layer 200b covers and protects the electrode layer 400b.

The first welding layer 500b is made from a portion of the base layer 100 and a portion of the protective layer 200b (i.e. respective portions of these layers contacting each other) that melt, get into interstices of electrodes 410b of the electrode layer 400b (to be described), bond to the base layer 100 and the protective layer 200b, and then solidify. The first welding layer 500b welds the entire surface areas of the base layer 100 and the protective layer 200b.

As shown in Fig. 1, the electrode layer 400b is provided between the base layer 100 and the protective layer 200b and embedded in the first welding layer 500b. As shown in Fig. 2, the electrode layer 400b has a plurality of strip-shaped electrodes 410b. The electrodes 410b have the same configuration as that of the electrodes 410a. The electrodes 410b of the electrode layers 400b are arrayed in spaced relation to each other along a second direction X. Accordingly, the electrodes 410b intersect with the electrodes 410a in plan position. The electrode layer 400b is also connectable to the connecting means mentioned above.

As shown in Fig. 1, the reinforcing layer 300b is laminated to the protective layer 200b and welded to the protective layer 200b by the second welding layer 600b. The reinforcing layer 300b is a flexible transparent plastic film, for example made of PET (polyethylene terephthalate), polycarbonate, PMMA (polymethyl methacrylate), or the like.

The second welding layer 600b is made from a portion of the protective layer 200b and a portion of the reinforcing layer 300b (i.e. respective portions of these layers contacting each other) that melt, bond to the protective layer 200b and the reinforcing layer 300b, and then solidify. The second welding layer 600b welds the entire surface areas of the protective layer 200b and the reinforcing layer 300b.

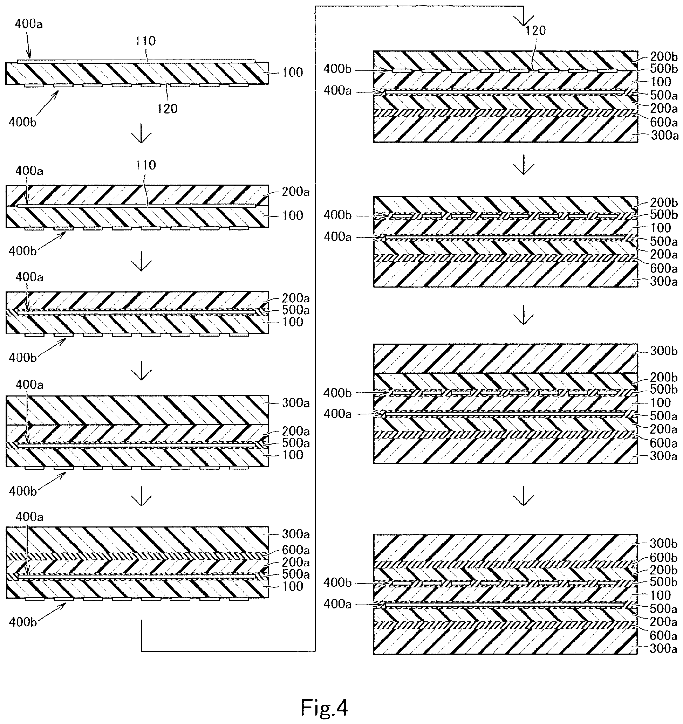

The touch sensor configured as described above may be manufactured in the following steps and as illustrated in Fig. 4. The first step is to prepare the base layer 100. On the first face 110 of the base layer 100 are formed the electrodes 410a of the electrode layer 400a spaced from each other along the first direction Y, while on the second face 120 of the base layer 100 are formed the electrodes 410b of the electrode layer 400b spaced from each other along the second direction X. The electrodes 410a thus intersect with the electrodes 410b in plan position. Alternatively, the electrodes 410a and 410b may be formed by forming a conductive film on each of the first face 110 and the second face 120 of the base layer 100, and patterning this film so as to form the electrodes 410a of the electrode layer 400a spaced from each other along the first direction Y on the first face 110 and the electrodes 410b of the electrode layer 400b spaced from each other along the second direction X on the second face 120.

The next step is to prepare the buffer layer 200a. The buffer layer 200a is laminated on the first face 110 of the base layer 100, so that the electrode layer 400a is located between the base layer 100 and the buffer layer 200a. The next step is to weld the base layer 100 and the buffer layer 200a together using a welding machine. It should be recalled here that the buffer layer 200a is made of a plastic material having a melting point lower than that of the base layer 100. Accordingly, the portion of the buffer layer 200a in contact with the base layer 100 melts, and then the portion of the base layer 100 in contact with the buffer layer 200a melts. Then, both the melted portions come into contact with each other through the interstices 411 a or 412a of the electrodes 410a of the electrode layer 400a, and then they solidify. The solidified portion becomes the first welding layer 500a. The first welding layer 500a is thus bonded to the base layer 100 and the buffer layer 200a, with the electrode layer 400a embedded in the first welding layer 500a.

The next step is to prepare the cover panel layer 300a. The cover panel layer 300a is laminated on the buffer layer 200a. Then, the buffer layer 200a and the cover panel layer 300a are welded together using a welding machine. It should be recalled here that the buffer layer 200a is made of a thermoplastic plastic having a melting point lower than that of the cover panel layer 300a. Accordingly, the portion of the buffer layer 200a in contact with the cover panel layer 300a melts, and then the portion of the cover panel layer 300a in contact with the buffer layer 200a melts. Then, both the melted portions come into contact with each other and then solidify. The solidified portion becomes the second welding layer 600a. The second welding layer 600a is thus bonded to the buffer layer 200a and the cover panel layer 300a.

The next step is to prepare the protective layer 200b. The protective layer 200b is laminated on the second face 120 of the base layer 100, so that the electrode layer 400b is located between the base layer 100 and the protective layer 200b. The next step is to weld the base layer 100 and the protective layer 200b using a welding machine. More particularly, the portion of the base layer 100 in contact with the protective layer 200b and a portion of the protective layer 200b in contact with the base layer 100 melt, come in contact with each other through the interstices of the electrodes 410b of the electrode layer 400b, and then solidify. The solidified portion becomes the first welding layer 500b. The first welding layer 500b is thus bonded to the base layer 100 and the protective layer 200b, with the electrode layer 400b embedded in the first welding layer 500b.

The next step is to prepare the reinforcing layer 300b. The reinforcing layer 300b is laminated on the protective layer 200b. Then, the protective layer 200b and the reinforcing layer 300b are welded together in the welding machine. More particularly, the portion of the protective layer 200b in contact with the reinforcing layer 300b and the portion of the reinforcing layer 300b in contact with the protective layer 200b melt, come in contact with each other, and then solidify. The solidified portion becomes the second welding layer 600b. The second welding layer 600b is thus bonded to the protective layer 200b and the reinforcing layer 300b. This is how to manufacture the touch panel T. It should be noted that the welding processes discussed above may be performed by thermal welding, ultrasonic welding, high-frequency welding, semiconductor laser welding, or other means.

The touch sensor T described above has many technical features as discussed below. First, the first welding layer 500a welds the entire surface areas of the base layer 100 and the buffer layer 200a together, and the first welding layer 500b welds the entire surface areas of the base layer 100 and the protective layer 200b together. Also, the second welding layer 600a welds the entire surface areas of the buffer layer 200a and the cover panel layer 300a together, and the second welding layer 600b welds the entire surface areas of the protective layer 200b and the reinforcing layer 300b together. These structures can improve bonding strengths between the base layer 100 and the buffer layer 200a, between the base layer 100 and the protective layer 200b, between the buffer layer 200a and the cover panel layer 300a, and between the protective layer 200b and the reinforcing layer 300b. Hence, if used under a harsh environment (such as under a high-temperature environment or if bent in a curved shape), the touch sensor T is less likely to suffer from delamination between the base layer 100 and the buffer layer 200a, between the base layer 100 and the protective layer 200b, between the buffer layer 200a and the cover panel layer 300a, and/or between the protective layer 200b and the reinforcing layer 300b.

Further advantageously, the first welding layer 500a is made from portions of the base layer 100 and the buffer layer 200a that have melted and then solidified. The first welding layer 500b is made from portions of the base layer 100 and the protective layer 200b that have melted and then solidified. The second welding layer 600a is made from portions of the buffer layer 200a and the cover panel layer 300a that have melted and then solidified. The second welding layer 600b is made from portions of the protective layer 200b and the reinforcing layer 300b that have melted and then solidified. These structures do not require additional members for bonding the base layer 100 and the buffer layer 200a, the base layer 100 and the protective layer 200b, the buffer layer 200a and the cover panel layer 300a, and the protective layer 200b and the reinforcing layer 300b. Therefore, the touch sensor T has a reduced number of components and can be manufactured with a reduced number of welding processes, so that the touch sensor T can be manufactured with a reduced cost.

Still advantageously, the buffer layer 200a is interposed between the base layer 100 and the cover panel layer 300a. If the base layer 100 and the cover panel layer 300a have poor welding compatibility with each other, the buffer layer 200a can act as an intermediary in bonding the base layer 100 and the cover panel layer 300a together. Also, the buffer layer 200a is made of a thermoplastic plastic material having a melting point lower than those of the base layer 100 and the cover panel layer 300a, a portion of the base layer 200a melts before portions of the base layer 100 and the cover panel layer 300a do. This can reduce thermal damage to the base layer 100 and the cover panel layer 300a during the welding process.

Further advantageously, the protective layer 200b, serving as a protective layer to cover the electrode layer 400b, can prevent the electrode layer 400b from coming in direct contact with the welding machine during the welding process. Therefore, the electrode layer 400b is less likely to be physically damaged during the welding process.

### Second embodiment

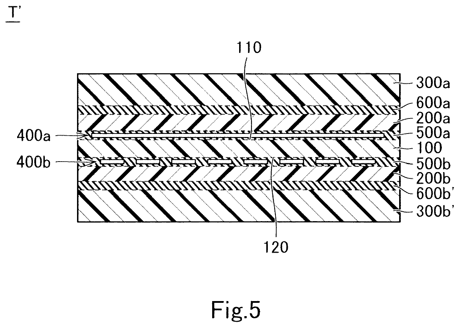

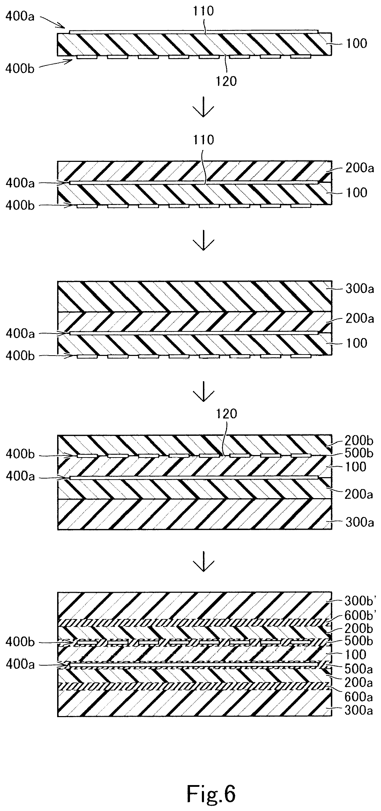

Next, a touch sensor T' according to the second embodiment of the invention will be described with reference to Figs. 5 and 6. The touch sensor T' shown in Fig. 5 has the same configuration as the touch sensor T except for a reinforcing layer 300b' and a second welding layer 600b', which has a different configuration from that of the touch sensor T of the first embodiment. This difference will be described in detail, while overlapping descriptions are omitted. A symbol _'_ is added to the reinforcing layer 300b and the second welding layer 600b of this embodiment for the purpose of distinction from those in the first embodiment.

The reinforcing layer 300b' is a rigid plate made of polycarbonate, acrylic, or other plastic material. This reinforcing layer 300b' is also laminated to the protective layer 200b and welded in the entire surface area to the protective layer 200b by the second welding layer 600b'.

The touch sensor T' described above may be manufactured in the following steps and as illustrated in Fig. 6. First, similarly to the first embodiment, the electrodes 410a of the electrode layer 400a are formed on the first face 110 of the base layer 100, and the electrodes 410b of the electrode layer 400b are formed on the second face 120 of the base layer 100.

The next step is to prepare the buffer layer 200a. The buffer layer 200a is laminated on the first face 110 of the base layer 100, so that the electrode layer 400a is located between the base layer 100 and the buffer layer 200a. The next step is to prepare the cover panel layer 300a. The cover panel layer 300a is laminated on the buffer layer 200a. Also prepared is the protective layer 200b. The protective layer 200b is laminated on the second face 120 of the base layer 100, so that the electrode layer 400b is located between the base layer 100 and the protective layer 200b.

The next step is to place the cover panel layer 300a, the buffer layer 200a, the electrode layer 400a, the base layer 100, the electrode layer 400b, and the protective layer 200b into a die of an injection molding machine. Then, polycarbonate, acrylic, or other plastic material is injected for molding onto the protective layer 200b in the die. The plastic material hardens on the protective layer 200b to become the reinforcing layer 300b'. The reinforcing layer 300b' is thus laminated on the protective layer 200b. In this molding process, a portion of the plastic material is welded to the protective layer 200b to form the second welding layer 600b'.

Simultaneously in the die, the heat and pressure during the injection molding process causes welding of the base layer 100 and the buffer layer 200a, the buffer layer 200a and the cover panel layer 300a, and the base layer 100 and the protective layer 200b. More specific welding processes are as follows.

By use of the heat and pressure during the injection molding process, the portion of the buffer layer 200a in contact with the base layer 100 melts, and then the portion of the base layer 100 in contact with the buffer layer 200a melts. Both the melted portions come in contact with each other through the interstices 411 a or 412a of the electrodes 410a of the electrode layer 400a, and then they solidify. The solidified portion becomes the first welding layer 500a. The first welding layer 500a is thus bonded to the base layer 100 and the buffer layer 200a, with the electrode layer 400a embedded in the first welding layer 500a.

By use of the heat and pressure during the injection molding process, the portion of the buffer layer 200a in contact with the cover panel layer 300a melts, and then the portion of the cover panel layer 300a in contact with the buffer layer 200a melts. Both the melted portions contact each other and then solidify. The solidified portion becomes the second welding layer 600a. The second welding layer 600a is thus bonded to the buffer layer 200a and the cover panel layer 300a.

By use of the heat and pressure during the injection molding process, the portion of the base layer 100 in contact with the protective layer 200b and the portion of the protective layer 200b in contact with the base layer 100 melt, come in contact with each other through the interstices of the electrodes 410b of the electrode layer 400b, and then they solidify. The solidified portion becomes the first welding layer 500b. The first welding layer 500b is thus bonded to the base layer 100 and the protective layer 200b, with the electrode layer 400b embedded in the first welding layer 500b.

The touch sensor T' described above provides the same effects as those provided by the touch sensor T. In addition, the heat and pressure during the injection molding process can be effectively used for forming the first welding layers 500a and 500b and the second welding layers 600a and 600b'. Therefore, the touch sensor T' can be manufactured with a reduced number of welding processes, so that the touch sensor T' can be manufactured with a reduced cost.

It is appreciated that the above touch sensors T and T' and the methods for manufacturing them are not limited to those of the above first and second embodiments, and they may be modified in any manner within the scope of the claims. Some specific modifications will be described below.

According to the above first and second embodiments, the touch sensor includes the base layer, the buffer layer, the protective layer, the cover panel layer, the reinforcing layer, the electrode layer, the first welding layer, and the second welding layer. However, the touch sensor of the invention may be modified in any manner as long as it includes laminated first and second layers, and a first welding layer being provided between the first and second layers and welding the first layer and the second layer together at least partially.

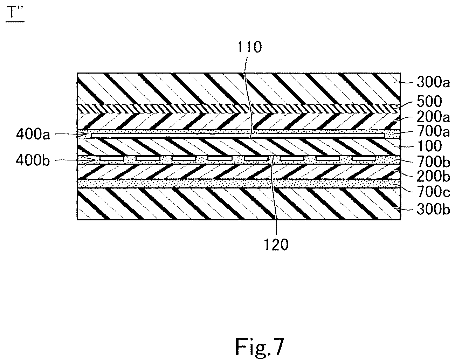

The above first and second embodiments prescribe that the base layer 100 is the first layer and the buffer layer 200a and the protective layer 200b are each the second layer. However, the first and second layers of the invention may be any adjacent layers of a plurality of laminated layers in a touch sensor. For example, Fig. 7 illustrates a variant touch sensor T", in which the cover panel layer 300a is a first layer, and the buffer layer 200a is a second layer.

In the touch sensor T", the entire surface areas of the cover panel layer 300a and the buffer layer 200a are welded together by a first welding layer 500. The first welding layer 500 is made from a portion of the cover panel layer 300a and a portion of the buffer layer 200a (i.e. respective portions of these layers contacting each other) that melt, bond to the cover panel layer 300a and the buffer layer 200a, and then solidify. The base layer 100 and the buffer layer 200a are bonded together by an optically clear adhesive 700a. The base layer 100 and the protective layer 200b are bonded together by an optically clear adhesive 700b. The protective layer 200b and the reinforcing layer 300b are bonded by an optically clear adhesive 700c.

The touch sensor T" may be manufactured in the following steps. First, the electrodes 410a of the electrode layer 400a are formed on the first face 110 of the base layer 100, and the electrodes 410b of the electrode layer 400b are formed on the second face 120 of the base layer 100. Then, the buffer layer 200a is bonded to the first face 110 of the base layer 100 by the optically clear adhesive 700a. Then, the cover panel layer 300a is laminated on the buffer layer 200a. Then, the buffer layer 200a and the cover panel layer 300a are welded together using a welding machine. It should be recalled here that the buffer layer 200a is made of a thermoplastic plastic having a melting point lower than that of the cover panel layer 300a, the portion of the buffer layer 200a in contact with the cover panel layer 300a melts, and then the portion of the cover panel layer 300a in contact with the buffer layer 200a melts. Then, both the melted portions come into contact with each other, and then they solidify. The solidified portion becomes the first welding layer 500. It should be noted that the above welding process may be performed by thermal welding, ultrasonic welding, high-frequency welding, semiconductor laser welding, or other means. Then, the protective layer 200b is bonded to the first face 110 of the base layer 100 by the optically clear adhesive 700b. Onto the protective layer 200b the reinforcing layer 300b is bonded by the optically clear adhesive 700c. This is how to manufacture the variant touch sensor T". Alternatively, the first welding layer 500 may be formed by use of the heat and pressure during the injection molding process as in the second embodiment.

The touch sensor of the invention may also be modified such that the reinforcing layer 300b serves as the first layer and the protective layer 200b serves as the second layer. In this case, the first welding layer may weld the entire surface areas of the reinforcing layer 300b and the protective layer 200b. The other interlayer bondings may be provided by an optically clear adhesive or an unclear adhesive.

In the first and second embodiments and some of the above modifications, the cover panel layer and the reinforcing layer each serve as the third layer. However, the third layer of the invention may be any layer laminated on the second layer. In the above first and second embodiments and the above modifications, the first, second, and third layers are all made of plastic materials, but all or any of the first, second, and third layers may be made of a material other than plastic material. In addition, one or a plurality of layers may be laminated on the third layer.

In the above first and second embodiments and the above modifications, the first welding layer and/or the second welding layer weld the entire surface areas of the layers to be laminated. However, the first welding layer and/or the second welding layer may be modified in any manner as long as they can weld layers to be laminated at least partially. The portions other than the welded portions of the layers may be bonded by an optically clear adhesive or an unclear adhesive. The first welding layer may be made from a portion of one layer of the first and second layers that has melted and then solidified to weld the one layer at least partially to the other layer of the first and second layers. The second welding layer may be made from a portion of one layer of the second and third layers that has melted and then solidified to weld the one layer at least partially to the other layer of the second and third layers. In addition, if the first, second, and third layers are made of a material other than plastic material, the first layer and the second layer and/or the second layer and the third layer may be welded together at least partially by a plastic material sandwiched between the first layer and the second layer and/or the second layer and the third layer. Also in a case where the first and second layers are made of a material other than a plastic material and the electrode layer is formed on the first layer, the first layer and the second layer may be welded together by a plastic material sandwiched between the first layer and the second layer. In the case where the electrodes of the electrode layer are in mesh or fibrous form, the sandwiched plastic material may melt, come in contact with the second layer through the interstices of the electrodes, and then solidify. The solidified plastic may serve as the first welding layer to weld the first layer and the second layer.

In the above first and second embodiments and the above modifications, the buffer layer is provided between the cover panel layer and the base layer. The buffer layer may be replaced with a protective layer to be disposed between the cover panel layer and the base layer. In the above first and second embodiments and the above modifications, the protective layer is provided between the reinforcing layer and the base layer. The protective layer may be replaced with a buffer layer to be disposed between the reinforcing layer and the base layer.

In the above first and second embodiments and the above modifications, the buffer layer is provided between the cover panel layer (the third layer) and the base layer (the first layer) and is made of a thermoplastic plastic material having a relatively low melting point. However, the buffer layer of the invention may be modified in any manner as long as it is provided between the first and third layers and made of a plastic material more suitable to be welded to the first and third layers than welding the first and third layers to one another directly.

In the above first and second embodiments and the above modifications, the electrode layer 400a is formed on the first face 110 of the base layer 100, and the electrode layer 400b is formed on the second face 120 of the base layer 100. However, the electrode layers 400a and 400b may be provided on one and the same face of the base in the thickness direction. In this case, an insulating layer may be provided between the electrode layers 400a and 400b.

In the above first and second embodiments and the above modifications, the electrodes 410a and 410b of the electrode layers 400a and 400b are in mesh or fibrous form. However, the electrodes of the electrode layer of the invention may be a solid filling such as transparent conductive films of ITO (indium tin oxide), PEDOT (polyethylenedioxythiophene), or other material. The electrodes of the electrode layer may be optically opaque. Further, the electrode layer may require at least one electrode. This modification applies to cases such as when the touch sensor is a touch switch as discussed below.

In the above first and second embodiments and the above modifications, the base layer is a flexible transparent plastic film. However, the base layer of the invention may be a translucent plastic film, an opaque plastic film, a translucent rigid substrate (e.g. a glass or ceramic substrate), or an opaque rigid substrate. Any of the buffer layer, the cover panel layer, the protective layer, and the reinforcing layer of the above first and second embodiments and the above modifications may also be a translucent plastic film, an opaque plastic film, a translucent rigid substrate (e.g. a glass or ceramic substrate), or an opaque rigid substrate.

The touch sensors of the above first and second embodiments and the above modifications may be manufactured by any method including laminating the first and second layers together, at least one layer of the first and second layers being a plastic layer, and welding the one layer at least partially to the other layer of the first and second layers by melting and then solidifying a portion of the one layer. The manufacturing method may further include placing the laminated first and second layers in a die, and injection-molding a plastic material on the second layer in the die to laminate a third layer on the second layer. In this case, the welding of the one layer at least partially to the other layer may includes melting the portion of the one layer of the first and second layers by use of heat and pressure during the injection molding process and solidifying the melted portion of the one layer.

It should be appreciated that the embodiments and modifications are described above by way of example only. The materials, shapes, dimensions, numbers, arrangements, and other configurations of the touch sensors may be modified in any manner if they can perform similar functions. The touch sensor of the invention may be a capacitive touch panel as described above but is not limited thereto. For example, the touch sensor may be a touch panel of a type other than capacitive (e.g. resistive type and in-cell type), or a touch switch (touch switch of capacitive, resistive, in-cell, or other type). Furthermore, the invention is not limited to touch sensors but applicable to any devices having a plurality of layers bonded to each other.

### Reference Signs List

T: Touch sensor
100: Base layer (first layer)
200a: Buffer layer (second layer)
200b: Protective layer (second layer)
300a: Cover panel layer (third layer)
300b: Reinforcing layer (third layer)
400a: Electrode layer
410a: Electrode
400b: Electrode layer
410b: Electrode
500a: First welding layer
500b: First welding layer
600a: Second welding layer
600b: Second welding layer

## Claims

1. A touch sensor comprising:
first (100) and second (200a, 200b) layers laminated together; and
a first welding layer (500a, 500b) being provided between the first and second layers and welding the first and second layers together at least partially;
an electrode layer (400a, 400b) provided between the first (100) and second (200a, 200b) layers; wherein
the electrode layer (400a, 400b) comprises a meshed or fibrous electrode (410a, 410b) including interstices (411a, 412a), and
the first welding layer (500a, 500b) welds to the other layer (100, 200a, 200b) through interstices of the electrode.

2. The touch sensor according to claim 1, wherein
at least one layer of the first (100) and second (200a, 200b) layers is a plastic layer, and
the first welding layer (500a, 500b) is made from a portion of the one layer that has melted and then solidified to weld the one layer at least partially to the other layer of the first and second layers.

3. The touch sensor according to claim 1 or claim 2, further comprising:
a third layer (300a, 300b, 300b') laminated to the second layer (200a, 200b); and
a second welding layer (600a, 600b, 600b') being provided between the second and third layers and welding the second and third layers together at least partially.

4. The touch sensor according to claim 3, wherein
at least one layer of the second (200a, 200b) and third (300a, 300b, 300b') layers is a plastic layer,
the second welding layer (600a, 600b, 600b') is made from a portion of the one layer of the second and third layers that has melted and then solidified to weld the one layer at least partially to the other layer of the second and third layers.

5. The touch sensor according to claim 3 or claim 4, wherein
the second layer (600a, 600b) is a buffer layer made of a plastic material more suitable to be welded to the first (100) and third (300a, 300b) layers than to weld the first and third layers together,
the first welding layer (500a, 500b) is made from a portion of the buffer layer that has melted and then solidified to weld the buffer layer to the first layer, and
the second welding layer (600a, 600b) is made from another portion of the buffer layer melted and then solidified to weld the buffer layer to the third layer.

6. The touch sensor according to claim 5, wherein
the buffer layer (200a, 200b) is made of a thermoplastic plastic material having a melting point lower than those of the first (100) and third (300a, 300b) layers.

7. A method of manufacturing a touch sensor comprising:
sandwiching a plastic material between first (100) and second (200a, 200b) layers, with an electrode layer (400a, 400b) formed on the first layer; and
welding the first and second layers together at least partially by melting and then solidifying the plastic material; wherein
the electrode layer (400a, 400b) comprises a meshed or fibrous electrode (410a, 410b) including interstices (411a, 412a), and
the welding of the first (100) and second (200a, 200b) layers together at least partially includes bonding the melted plastic material to the second layer through interstices of the electrode and then solidifying the melted plastic material.

8. A method of manufacturing a touch sensor comprising:
forming an electrode layer (400a, 400b) on one of a first (100) and a second (200a, 200b) layer, at least one layer of the first and second layers being a plastic layer;
laminating the first (100) and second (200a, 200b) layers together; and
welding the one layer at least partially to the other layer of the first and second layers by melting and then solidifying a portion of the one layer; wherein
the electrode layer (400a, 400b) comprises a meshed or fibrous electrode (410a, 410b) including interstices (411a, 412a), and
the welding of the one layer (100, 200a, 200b) at least partially to the other layer (100, 200a, 200b) includes bonding a melted portion of the one layer to the other layer through interstices of the electrode and then solidifying the melted portion of the one layer.

9. The method of manufacturing the touch sensor according to claim 8, further comprising:
placing the laminated first (100) and second (200a, 200b) layers in a die; and
injection-molding a plastic material on the second layer in the die to laminate a third layer (300b') on the second layer (200b);
wherein the welding of the one layer (100, 200a, 200b) at least partially to the other layer (100, 200a, 200b) includes:
melting the portion of the one layer of the first and second layers by use of heat and pressure during the injection molding process; and
solidifying the melted portion of the one layer.

10. The method of manufacturing the touch sensor according to claim 8 or claim 9, wherein one layer of the second layer (200a, 200b) and a third layer (300a, 300b) is made of a plastic material, and
the method further comprises:
laminating the third layer on the second layer, and
welding the one layer at least partially to the other layer of the second and third layers by melting and then solidifying a portion of the one layer.

11. The method of manufacturing the touch sensor according to claim 9 or claim 10, wherein
the second layer (200a, 200b) is a buffer layer made of a plastic material more suitable to be welded to the first (100) and third (300a, 300b) layers than to weld the first and third layers together.

12. The method of manufacturing the touch sensor according to claim 11,
the buffer layer (200a, 200b) is made of a thermoplastic plastic material having a melting point lower than those of the first (100) and third (300a, 300b) layers.

## Patentansprüche

1. Berührungssensor, umfassend:
aufeinander geschichtete erste (100) und zweite (200a, 200b) Schichten und
eine erste Schweißschicht (500a, 500b), die zwischen der ersten und der zweiten Schicht vorgesehen ist und die erste und die zweite Schicht zumindest teilweise zusammenschweißt;
eine Elektrodenschicht (400a, 400b), die zwischen der ersten (100) und der zweiten (200a, 200b) Schicht vorgesehen ist; wobei
die Elektrodenschicht (400a, 400b) eine gitter- oder faserartige Elektrode (410a, 401b) umfasst, die Zwischenräume (411a, 412a) enthält, und
die erste Schweißschicht (500a, 500b) durch Zwischenräume der Elektrode an die andere Schicht (100, 200a, 200b) geschweißt ist.

2. Berührungssensor nach Anspruch 1, wobei
die erste (100) und/oder die zweite (200a, 200b) Schicht eine Kunststoffschicht ist und
die erste Schweißschicht (500a, 500b) aus einem Abschnitt der einen Schicht hergestellt ist, der geschmolzen und dann verfestigt worden ist, um die eine Schicht zumindest teilweise an die andere Schicht der ersten und der zweiten Schicht zu schweißen.

3. Berührungssensor nach Anspruch 1 oder 2, ferner umfassend:
eine dritte Schicht (300a, 300b, 300b'), die auf die zweite Schicht (200a, 200b) geschichtet ist; und
eine zweite Schweißschicht (600a, 600b, 600b'), die zwischen der zweiten und der dritten Schicht vorgesehen ist und die zweite und die dritte Schicht zumindest teilweise zusammenschweißt.

4. Berührungssensor nach Anspruch 3, wobei die zweite (200a, 200b) und/oder die dritte (300a, 300b, 300b') Schicht eine Kunststoffschicht ist,
die zweite Schweißschicht (600a, 600b, 600b') aus einem Abschnitt der einen Schicht der zweiten und der dritten Schicht hergestellt ist, die geschmolzen und dann verfestigt worden ist, um die eine Schicht zumindest teilweise an die andere Schicht der zweiten und der dritten Schicht zu schweißen.

5. Berührungssensor nach Anspruch 3 oder 4, wobei
die zweite Schicht (600a, 600b) eine Pufferschicht ist, die aus einem Kunststoffmaterial hergestellt ist, das zum Anschweißen an die erste (100) und die dritte (300a, 300b) Schicht geeigneter ist als zum Zusammenschweißen der ersten und der dritten Schicht,
die erste Schweißschicht (500a, 500b) aus einem Abschnitt der Pufferschicht hergestellt ist, der geschmolzen und dann verfestigt worden ist, um die Pufferschicht an die erste Schicht zu schweißen, und
die zweite Schweißschicht (600a, 600b) aus einem anderen Abschnitt der Pufferschicht hergestellt ist, der geschmolzen und dann verfestigt worden ist, um die Pufferschicht an die dritte Schicht zu schweißen.

6. Berührungssensor nach Anspruch 5, wobei
die Pufferschicht (200a, 200b) aus einem thermoplastischen Kunststoffmaterial mit einem Schmelzpunkt unterhalb derer der ersten (100) und der dritten (300a, 300b) Schicht hergestellt ist.

7. Verfahren zum Herstellen eines Berührungssensors, umfassend:
sandwichartiges Anordnen eines Kunststoffmaterials zwischen einer ersten (100) und einer zweiten (200a, 200b) Schicht, wobei eine Elektrodenschicht (400a, 400b) auf der ersten Schicht gebildet wird; und
zumindest teilweises Zusammenschweißen der ersten und der zweiten Schicht durch Schmelzen und dann Verfestigen des Kunststoffmaterials; wobei
die Elektrodenschicht (400a, 400b) eine gitter- oder faserartige Elektrode (410a, 410b) umfasst, die Zwischenräume (411a, 412a) enthält, und
das zumindest teilweise Zusammenschweißen der ersten (100) und der zweiten (200a, 200b) Schicht das Bonden des geschmolzenen Kunststoffmaterials durch Zwischenräume der Elektrode an die zweite Schicht und dann das Verfestigen des geschmolzenen Kunststoffmaterials beinhaltet.

8. Verfahren zum Herstellen eines Berührungssensors, umfassend:
Bilden einer Elektrodenschicht (400a, 400b) auf einer ersten (100) und einer zweiten (200a, 200b) Schicht, wobei zumindest eine Schicht der ersten und der zweiten Schicht eine Kunststoffschicht ist;
Schichten der ersten (100) und der zweiten (200a, 200b) Schicht aufeinander und
Schweißen der einen Schicht zumindest teilweise an die andere Schicht der ersten und der zweiten Schicht durch Schmelzen und Verfestigen eines Abschnitts der einen Schicht; wobei
die Elektrodenschicht (400a, 400b) eine gitter- oder faserartige Elektrode (410a, 410b) umfasst, die Zwischenräume (411a, 412a) enthält, und
das Schweißen der einen Schicht (100, 200a, 200b) zumindest teilweise an die andere Schicht (100, 200a, 200b) das Bonden eines geschmolzenen Abschnitts der einen Schicht durch Zwischenräume der Elektrode an die andere Schicht und dann das Verfestigen des geschmolzenen Abschnitts der einen Schicht beinhaltet.

9. Verfahren zum Herstellen eines Berührungssensors nach Anspruch 8, ferner umfassend:
Plazieren der geschichteten ersten (100) und zweiten (200a, 200b) Schichten in einer Gussform und
Spritzgießen eines Kunststoffmaterials auf die zweite Schicht in der Gussform, um eine dritte Schicht (300b') auf die zweite Schicht (200b) zu schichten;
wobei das Schweißen der einen Schicht (100, 200a, 200b) zumindest teilweise an die andere Schicht (100, 200a, 200b) beinhaltet:
Schmelzen des Abschnitts der einen Schicht der ersten und der zweiten Schicht durch Verwendung von Wärme und Druck während des Spritzgussvorgangs und
Verfestigen des geschmolzenen Abschnitts der einen Schicht.

10. Verfahren zum Herstellen des Berührungssensors nach Anspruch 8 oder 9, wobei eine Schicht der zweiten Schicht (200a, 200b) und einer dritten Schicht (300a, 300b) aus einem Kunststoffmaterial hergestellt ist, und
das Verfahren ferner umfasst:
Schichten der dritten Schicht auf die zweite Schicht und
Schweißen der einen Schicht zumindest teilweise an die andere Schicht der zweiten und der dritten Schicht durch Schmelzen und dann Verfestigen eines Abschnitts der einen Schicht.

11. Verfahren zum Herstellen des Berührungssensors nach Anspruch 9 oder 10, wobei
die zweite Schicht (200a, 200b) eine Pufferschicht ist, die aus einem Kunststoffmaterial hergestellt ist, das zum Schweißen an die ersten (100) und dritten (300a, 300b) Schichten geeigneter ist als zum Zusammenschweißen der ersten und dritten Schichten.

12. Verfahren zum Herstellen des Berührungssensors nach Anspruch 11,
wobei die Pufferschicht (200a, 200b) aus einem thermoplastischen Kunststoffmaterial mit einem Schmelzpunkt unterhalb derer der ersten (100) und dritten (300a, 300b) Schichten hergestellt ist.

## Revendications

1. Capteur tactile comprenant :
des première (100) et deuxième (200a, 200b) couches reliées par stratification ; et
une première couche de soudage (500a, 500b) qui est prévue entre les première et deuxième couches et qui les soude l'une à l'autre au moins en partie ;
une couche d'électrodes (400a, 400b) prévue entre les première (100) et deuxième (200a, 200b) couches ;
la couche d'électrodes (400a, 400b) comprenant une électrode maillée ou fibreuse (410a, 410b) avec des interstices (411a, 412a), et
la première couche de soudage (500a, 500b) se soudant à l'autre couche (100, 200a, 200b) à travers les interstices de l'électrode.

2. Capteur tactile selon la revendication 1, dans lequel
l'une au moins des première (100) et deuxième (200a, 200b) couches est une couche de matière plastique, et
la première couche de soudage (500a, 500b) se compose d'une partie de la couche qui a fondu puis s'est solidifiée pour souder ladite couche au moins partiellement à l'autre des première et deuxième couches.

3. Capteur tactile selon la revendication 1 ou la revendication 2, comprenant également :
une troisième couche (300a, 300b, 300b') appliquée par stratification sur la deuxième couche (200a, 200b) ; et
une deuxième couche de soudage (600a, 600b, 600b') qui est prévue entre les deuxième et troisième couches et qui les soude l'une à l'autre au moins en partie.

4. Capteur tactile selon la revendication 3, dans lequel
l'une au moins des deuxième (200a, 200b) et troisième (300a, 300b, 300b') couches est une couche de matière plastique, et
la deuxième couche de soudage (600a, 600b, 600b') se compose d'une partie de la couche, parmi les deuxième et troisième couches, qui a fondu puis s'est solidifiée pour souder ladite couche au moins partiellement à l'autre des deuxième et troisième couches.

5. Capteur tactile selon la revendication 3 ou la revendication 4, dans lequel
la deuxième couche (600a, 600b) est une couche tampon composée d'une matière plastique plus apte à être soudée aux première (100) et troisième (300a, 300b) couches qu'à souder les première et troisième couches l'une à l'autre,
la première couche de soudage (500a, 500b) se compose d'une partie de la couche tampon qui a fondu puis s'est solidifiée pour souder ladite couche tampon à la première couche, et
la deuxième couche de soudage (600a, 600b) se compose d'une autre partie de la couche tampon qui a fondu puis s'est solidifiée pour souder ladite couche tampon à la troisième couche,

6. Capteur tactile selon la revendication 5, dans lequel
la couche tampon (200a, 200b) se compose d'une matière thermoplastique qui présente un point de fusion inférieur à celui des première (100) et troisième (300a, 300b) couches.

7. Procédé pour fabriquer un capteur tactile, comprenant les mesures qui consistent à :
placer en sandwich une matière plastique entre des première (100) et deuxième (200a, 200b) couches, une couche d'électrodes (400a, 400b) étant formée sur la première couche ; et
souder les première et deuxième couches l'une à l'autre au moins en partie par fusion puis solidification de la matière plastique ;
la couche d'électrodes (400a, 400b) comprenant une électrode maillée ou fibreuse (410a, 410b) avec des interstices (411a, 412a), et
le soudage des première (100) et deuxième (200a, 200b) couches l'une à l'autre comprend au moins en partie la liaison entre la matière plastique fondue et la deuxième couche à travers les interstices de l'électrode, puis la solidification de la matière plastique fondue.

8. Procédé pour fabriquer un capteur tactile, comprenant les mesures qui consistent à :
former une couche d'électrodes (400a, 400b) sur l'une des première (100) et deuxième (200a, 200b) couches, l'une au moins des première et deuxième couches étant une couche de matière plastique ;
relier par stratification les première (100) et deuxième (200a, 200b) couches ; et
souder une couche au moins partiellement à l'autre des première et deuxième couches par fusion puis solidification d'une partie de ladite couche ;
la couche d'électrodes (400a, 400b) comprenant une électrode maillée ou fibreuse (410a, 410b) avec des interstices (411a, 412a), et
le soudage d'une couche (100, 200a, 200b) au moins en partie sur l'autre couche (100, 200a, 200b) comprenant au moins en partie la liaison entre une partie fondue de ladite couche et l'autre couche à travers les interstices de l'électrode, puis la solidification de la partie fondue de ladite couche.

9. Procédé pour fabriquer le capteur tactile selon la revendication 8, comprenant également les mesures qui consistent à :
placer les première (100) et deuxième (200a, 200b) couches stratifiées dans un moule ; et
mouler par injection une matière plastique sur la deuxième couche, dans le moule, pour appliquer par stratification une troisième couche (300b') sur la deuxième couche (200b) ;
le soudage d'une couche (100, 200a, 200b) au moins en partie sur l'autre couche (100, 200a, 200b) comprenant :
la fusion de la partie de la couche, parmi les première et deuxième couches, à l'aide de chaleur et de pression pendant l'opération de moulage par injection ; et
la solidification de la partie fondue de ladite couche.

10. Procédé pour fabriquer le capteur tactile selon la revendication 8 ou la revendication 9, une couche parmi la deuxième couche (200a, 200b) et une troisième couche (300a, 300b) étant en matière plastique, et
le procédé comprend également les mesures qui consistent à :
appliquer par stratification la troisième couche sur la deuxième couche, et
souder une couche au moins partiellement à l'autre, parmi les deuxième et troisième couches, par fusion puis solidification d'une partie de ladite couche.

11. Procédé pour fabriquer le capteur tactile selon la revendication 8 ou la revendication 9, la deuxième couche (200a, 200b) étant une couche tampon composée d'une matière plastique plus apte à être soudée aux première (100) et troisième (300a, 300b) couches qu'à souder les première et troisième couches l'une à l'autre.

12. Procédé pour fabriquer le capteur tactile selon la revendication 11, la couche tampon (200a, 200b) se composant d'une matière thermoplastique qui présente un point de fusion inférieur à celui des première (100) et troisième (300a, 300b) couches.
